# EUROPEAN PATENT APPLICATION

(11) **EP 4 362 071 A2**
(43) Date of publication of application: **01.05.2024**
(21) Application number: 23206096.2
(22) Date of filing: 26.10.2023
(51) Int. Cl.: H01L 21/60, H01L 23/538, H01L 21/56, H01L 23/31

(54) **PANEL LEVEL SEMICONDUCTOR PACKAGE AND METHOD OF MANUFACTURING THE SAME**

(30) Priority: 27.10.2022 US 202263419799 P; 18.10.2023 US 202318489746
(71) Applicant: STMicroelectronics Pte Ltd., Singapore 569508 (SG)
(72) Inventor: GANI, David, 689527 CHOA CHU KANG (SG)
(74) Representative: Casalonga

(57) **Abstract**

The present disclosure is directed to at least one semiconductor package including a die (204) within an encapsulant (202) having a first sidewall, an adhesive layer (222) on the encapsulant and having a second sidewall coplanar with the first sidewall of the encapsulant, and an insulating layer (226) on the adhesive layer having a third sidewall coplanar with the first sidewall and the second sidewall. A method of manufacturing the at least one semiconductor package includes forming an insulating layer on a temporary adhesion layer of a carrier, forming an adhesive layer on the insulating layer, and forming a plurality of openings through the adhesive layer and the insulating layer. The plurality of openings through the adhesive layer and the insulating layer may be formed by exposing the adhesive layer and the insulating layer to a laser.

## Description

### BACKGROUND

### Technical Field

The present disclosure is directed to a panel level semiconductor package, and a method of manufacturing the panel level semiconductor package.

### Description of the Related Art

Generally, panel level packaging techniques may be utilized for forming a semiconductor package in which a semiconductor die is encased. These panel level packaging techniques may include forming an opening through one or more insulating layers to expose a contact pad of the semiconductor die that was previously covered by an insulating layer. Forming the opening exposes the contact pad such that a conductive material may be formed on the contact pad such that an electrical pathway may be provided to the contact pad of the semiconductor die that may be utilized for forming an electrical connection with an electrical component external to the semiconductor package. The laser though may damage a surface of the contact pad on which the conductive material is to be formed. For example, the laser may cause a conductive material of the contact pad at the surface of the contact pad to become oxidized. This oxidization of the conductive material at the surface of the contact pad causes high resistance at the surface of the contact pad, which decreases the efficiency in an electrical signal that may travel to and from the semiconductor die within the semiconductor package.

### BRIEF SUMMARY

The present disclosure is directed to embodiments of methods of manufacturing embodiments of panel level semiconductor packages of the present disclosure that at least prevent damage (*e.g*., oxidization that generates high resistance) to a contact pad of a semiconductor die of the panel level semiconductor package.

In at least one embodiment of a panel level package (PLP) in which a semiconductor die is present, the semiconductor die is encased within an encapsulant and an adhesive layer. The adhesive layer is on a surface of the encapsulant and on a surface of the semiconductor die. The encapsulant includes a first sidewall and the adhesive layer includes a second sidewall, and the second sidewall of the adhesive layer is coplanar with the first sidewall of the encapsulant. One or more insulating layers may be on the adhesive layer and separated from the encapsulant by the adhesive layer. The one or more insulating layers may include one or more sidewalls that are coplanar with the first sidewall of the encapsulant and the second sidewall of the adhesive layer. A conductive structure extends through the one or more insulating layers and the adhesive layer to a contact pad of the semiconductor die.

In at least one embodiment of a method of manufacturing the PLP in which the semiconductor die is present, a panel wafer is formed on a temporary adhesion layer on a carrier. One or more insulating layers are formed on the temporary adhesion layer on the carrier, and an adhesive layer is formed on the one or more insulating layers. After the adhesive layer is formed, a plurality of openings are formed through the adhesive layer and the one or more insulating layers that extend to the temporary adhesion layer on the carrier. A plurality of die are coupled to the adhesive layer such that a contact pad of each die of the plurality of die overlaps at least one opening of the plurality of openings. An encapsulant is formed covering the plurality of die. After the encapsulant is formed, the panel wafer, which includes the encapsulant, the plurality of die, the adhesive layer, and the one or more insulating layers, is removed from the temporary adhesion layer on the carrier. After the panel level wafer is removed from the temporary adhesion layer on the carrier, a plurality of conductive structures are formed in the plurality of openings by forming a conductive material in the plurality of openings extending through the one or more insulating layers and the adhesive layer. After the conductive structures are formed, a plurality of solder balls are coupled to the plurality of conductive structures that were formed within the plurality of openings. After the plurality of solder balls are formed, the panel wafer is singulated along one or more singulation lines between a pair of adjacent die of the plurality of die forming the PLP in which at least one die of the plurality of die is present.

### BRIEF DESCRIPTION OF THE SEVERAL VIEWS OF THE DRAWINGS

For a better understanding of the present disclosure, some embodiments thereof are now described, purely by way of non-limiting example, with reference to the attached drawings. In the drawings, identical reference numbers identify the same or similar elements or acts unless the context indicates otherwise. The sizes and relative proportions of the elements in the drawings are not necessarily drawn to scale. For example, some of these elements may be enlarged and positioned to improve drawing legibility, in which:
Figures 1A and 1B are cross-sectional side views of one or more steps in a method of manufacturing a panel level package (PLP) with a laser;
Figure 2 is a cross-sectional side view of an embodiment of a PLP of the present disclosure;
Figure 3 is a cross-sectional side view of an alternative embodiment of a PLP of the present disclosure;
Figure 4 is a cross-sectional side view of an alternative embodiment of a PLP of the present disclosure;
Figure 5 is a cross-sectional side view of an alternative embodiment of a PLP of the present disclosure;
Figure 6 is a flowchart of an embodiment of a method of manufacturing the embodiment of the PLP of the present disclosure as shown in Figure 3;
Figures 7A-7H are cross-sectional side views of respective steps of the flowchart of the embodiment of the method of manufacturing as shown in Figure 6; and
Figure 8 is a cross-sectional side view of a respective step in an alternative embodiment of a method of manufacturing the alternative embodiment of the PLP as shown in Figure 3 of the present disclosure.

### DETAILED DESCRIPTION

In the following description, certain details are set forth in order to provide a thorough understanding of various embodiments of devices, methods and articles. However, one of skill in the art will understand that other embodiments may be practiced without these details. In other instances, well-known structures and methods associated with, for example, image sensors, semiconductor fabrication processes, etc., have not been shown or described in detail in some figures to avoid unnecessarily obscuring descriptions of the embodiments.

Unless the context requires otherwise, throughout the specification and claims which follow, the word "comprise" and variations thereof, such as "comprising," and "comprises," are to be construed in an open, inclusive sense, that is, as "including, but not limited to."

Reference throughout this specification to "one embodiment," or "an embodiment" means that a particular feature, structure or characteristic described in connection with the embodiment is included in at least one embodiment. Thus, the appearances of the phrases "in one embodiment," or "in an embodiment" in various places throughout this specification are not necessarily referring to the same embodiment, or to all embodiments. Furthermore, the particular features, structures, or characteristics may be combined in any suitable manner in one or more embodiments to obtain further embodiments.

The headings are provided for convenience only, and do not interpret the scope or meaning of this disclosure or the claims.

The sizes and relative positions of elements in the drawings are not necessarily drawn to scale. For example, the shapes of various elements and angles may not be drawn to scale, and some of these elements may be enlarged and positioned to improve drawing legibility. Further, the particular shapes of the elements as drawn are not necessarily intended to convey any information regarding the actual shape of particular elements, and have been selected solely for ease of recognition in the drawings. Geometric references are not intended to refer to ideal embodiments. For example, a reference to square-shaped does not mean that an element has a geometrically perfect square shape.

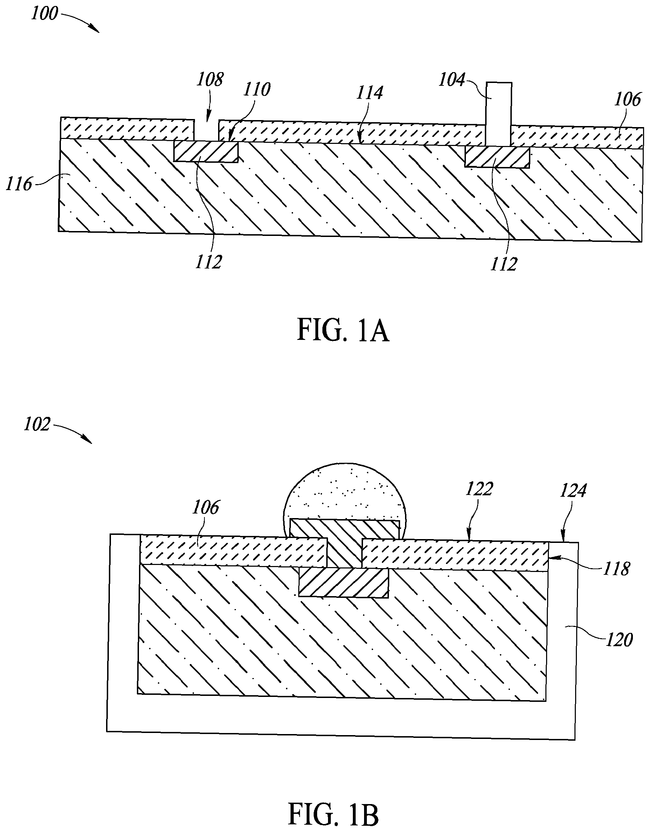

Generally, panel level packaging techniques may be utilized for forming a semiconductor package in which a semiconductor die is encased. These panel level packaging techniques may include forming an opening through one or more insulating layers to expose a contact pad of the semiconductor die that was previously covered by an insulating layer. Forming the opening exposes the contact pad such that a conductive material may be formed on the contact pad such that an electrical pathway may be provided to the contact pad of the semiconductor die that may be utilized for forming an electrical connection with an electrical component external to the semiconductor package. The laser though may damage a surface of the contact pad on which the conductive material is to be formed. For example, the laser may cause a conductive material of the contact pad at the surface of the contact pad to become oxidized. This oxidization of the conductive material at the surface of the contact pad causes high resistance at the surface of the contact pad, which decreases the efficiency in an electrical signal that may travel to and from the semiconductor die within the semiconductor package. A laser causing damage and/or oxidization at surfaces of contact pads may readily be seen in Figures 1A and 1B.

Figure 1A is a cross-sectional side view of a step 100 of a method of manufacturing a semiconductor package 102, which may be referred to as a panel level package (PLP), as shown in Figure 1B. In the step 100, a laser 104 is exposed to an insulating layer 106 to form a plurality of openings 108 that extend through the insulating layer 106 to surfaces 110 of a plurality of contact pads 112. Each respective opening 108 of the plurality of openings 108 is aligned with at least one respective contact pad 112 of the plurality of contact pads 112. The plurality of contact pads 112 are at a surface 114 of a substrate 116, and the surface 114 of the substrate 116 is covered by the insulating layer 106.

Figure 1B is a cross-sectional side view of the semiconductor package 102 after further processing steps after forming the plurality of openings 108 in the insulating layer 106. In the semiconductor package 102, the insulating layer 106 has sidewalls 118 that are covered by an encapsulant 120, and a surface 122 of the insulating layer 106 is coplanar with a surface 124 of the encapsulant 120.

As discussed above with respect to Figures 1A and 1B, when the laser 104 is utilized to form the plurality of openings 108 extending through the insulating layer 106, the surfaces 110 of the contact pads 112 may become exposed to the laser 104 such that oxidization of the contact pads 112 occurs at the surfaces 110 of the contact pads 112. When this oxidization occurs, the resistance at the surfaces 110 of the contact pads 112 increases resulting in an efficiency of an electrical signal passing through the contact pads 112 to be reduced in a manufactured panel level package (PLP) or panel level semiconductor package.

Another type of damage that may occur at the surfaces 110 of the contact pads 112 may be jaggedness or unevenness due to respective portions of the contact pads 112 being removed when exposed to the laser 104. This unevenness or jaggedness may result in unevenness of conductive structures that are utilized for mounting a manufactured semiconductor package to an external electrical component (*e.g*., a printed circuit board (PCB), a carrier, another semiconductor package, another semiconductor die, etc.), which may cause the manufactured semiconductor package to be angled or unlevel with respect to a surface of the external electrical component.

In view of the above discussion of the types of damage that may occur when the surfaces 110 of the contact pads 112 are exposed to the laser 104, the present disclosure is directed to embodiments of methods of manufacturing embodiments of panel level semiconductor packages of the present disclosure that at least prevent these types of damage and/or oxidization. For example, preventing the oxidization generation avoids generating a high resistance area on a surface of a contact pad, which improves an efficiency of an electrical signal that may pass through the contact pad that does not have the high resistance area, and preventing the unevenness or jaggedness improves a levelness of an embodiment of a semiconductor package of the present disclosure when mounted to an external electrical component (*e.g*., a printed circuit board (PCB), carrier, another semiconductor package, another semiconductor die, etc.).

For example, in at least one embodiment of a panel level package (PLP) in which a semiconductor die is present, the semiconductor die is encased within an encapsulant and an adhesive layer. The adhesive layer is on a surface of the encapsulant and on a surface of the semiconductor die. The encapsulant includes a first sidewall and the adhesive layer includes a second sidewall, and the second sidewall of the adhesive layer is coplanar with the first sidewall of the encapsulant. One or more insulating layers may be on the adhesive layer and separated from the encapsulant by the adhesive layer. The one or more insulating layers may include one or more sidewalls that are coplanar with the first sidewall of the encapsulant and the second sidewall of the adhesive layer. A conductive structure extends through the one or more insulating layers and the adhesive layer to a contact pad of the semiconductor die.

For example, in at least one embodiment of a method of manufacturing the PLP in which the semiconductor die is present, a panel wafer is formed on a temporary adhesion layer on a carrier. One or more insulating layers are formed on the temporary adhesion layer on the carrier, and an adhesive layer is formed on the one or more insulating layers. After the adhesive layer is formed, a plurality of openings are formed through the adhesive layer and the one or more insulating layers that extend to the temporary adhesion layer on the carrier. A plurality of die are coupled to the adhesive layer such that a contact pad of each die of the plurality of die overlaps at least one opening of the plurality of openings. An encapsulant is formed covering the plurality of die. After the encapsulant is formed, the panel wafer, which includes the encapsulant, the plurality of die, the adhesive layer, and the one or more insulating layers, is removed from the temporary adhesion layer on the carrier. After the panel level wafer is removed from the temporary adhesion layer on the carrier, a plurality of conductive structures are formed in the plurality of openings by forming a conductive material in the plurality of openings extending through the one or more insulating layers and the adhesive layer. After the conductive structures are formed, a plurality of solder balls are coupled to the plurality of conductive structures that were formed within the plurality of openings. After the plurality of solder balls are formed, the panel wafer is singulated along one or more singulation lines between a pair of adjacent die of the plurality of die forming the PLP in which at least one die of the plurality of die is present.

Utilizing the at least one embodiment of the method as discussed above prevents damage to a surface of the contact pad as the surface of the contact pad is not exposed to the laser when forming the plurality of openings through the adhesive layer and the one or more insulating layer. Instead, the plurality of openings through the adhesive layer and the one or more insulating layers is formed prior to coupling the plurality of die to the adhesive layer on the one or more insulating layers. This results in the surfaces of the contact pads of the plurality of die never being exposed to the laser preventing damage (*e.g*., oxidization) to the surfaces of the contact pads. Preventing this damage (*e.g*., oxidization) to the surfaces of the contact pads improves an efficiency of electrical signals sent to and from the PLP manufactured utilizing the at least one embodiment of the method of manufacturing as discussed above.

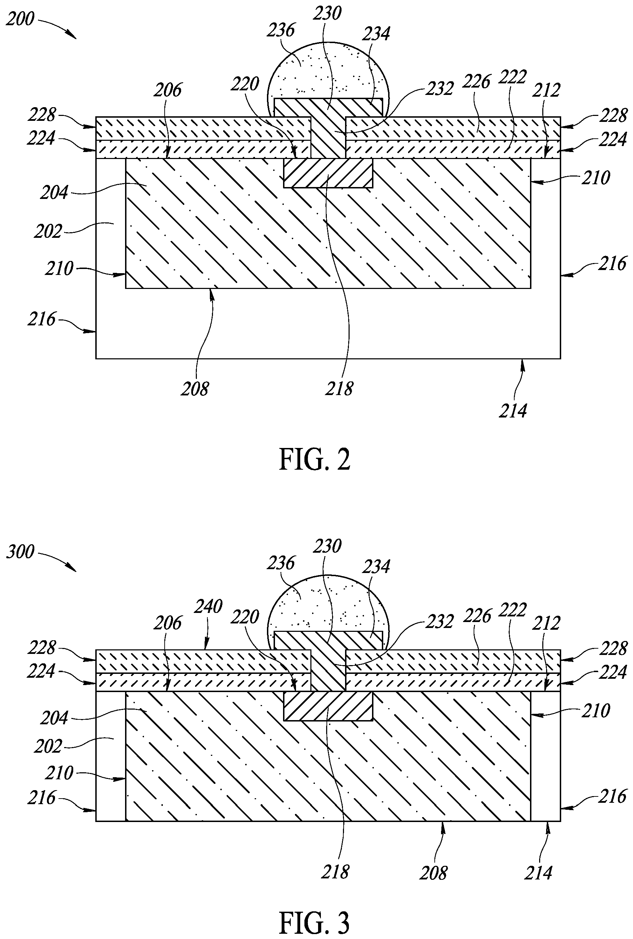

Figure 2 is a cross-sectional side view of an embodiment of a semiconductor package 200, which may be referred to as a panel level package (PLP), a panel level semiconductor package, or some other type of reference to the semiconductor package 200. The semiconductor package 200 includes an encapsulant 202 that is on a semiconductor die 204. The encapsulant 202 may be a molding compound, a resin material, an epoxy material, an insulating material, or some other type of non-conductive material. The die 204 includes a first surface 206 and a second surface 208 that is opposite to the first surface 206, and a plurality of sidewalls 210 that are transverse to the first and second surfaces 206, 208 and extend from the first surface 206 to the second surface 208. The encapsulant 202 covers the second surface 208 and the plurality of sidewalls 210. A first surface 212 of the encapsulant 202 is coplanar with the first surface 206 of the die 204, and a second surface 214 of the encapsulant 202 is opposite to the first surface 212 of the encapsulant 202 and faces away from the die 204. The encapsulant 202 includes a plurality of sidewalls 216 that are transverse to the first and second surfaces 212, 214 of the die 204, and the plurality of sidewalls 216 of the encapsulant 202 are spaced laterally outward from the plurality of sidewalls 210 of the die 204, respectively, based on the orientation of the semiconductor package 200 as in Figure 2.

The die 204 includes a contact pad 218 at the first surface 206 of the die 204. The contact pad 218 includes a surface 220 that is coplanar with the first surface 206 of the die 204. The contact pad 218 is in electrical communication with electrical components (not shown) of the die 204. For example, the electrical components (not shown) of the die 204 may include electrically active or electrically passive components within the die 204.

An adhesive layer 222 is on the first surface 212 of the encapsulant 202 and is on the surface 220 of the contact pad 218. The adhesive layer 222 may be a die attach film, a non-conductive glue, or some other suitable type of non-conductive adhesive material. The adhesive layer 222 includes a plurality of sidewalls 224 that are coplanar with the plurality of sidewalls 216 of the encapsulant 202. In other words, each respective sidewall of the plurality of sidewalls 224 of the adhesive layer 222 is coplanar with a corresponding respective sidewall of the plurality of sidewalls 216 of the encapsulant 202.

An insulating layer 226 is on the adhesive layer 222. The insulating layer 226 may be made of a non-conductive material, a non-conductive passivation material, a non-conductive repassivation material, or may be made of some other suitable type of non-conductive material. The insulating layer 226 includes a plurality of sidewalls 228 that are coplanar with the plurality of sidewalls 224 of the adhesive layer 222 and coplanar with the plurality of sidewalls 216 of the encapsulant 202. In other words, each respective sidewall of the plurality of sidewalls 228 of the adhesive layer 222 is coplanar with a corresponding respective sidewall of the plurality of sidewalls 224 of the adhesive layer 222 and is coplanar with a corresponding respective sidewall of the plurality of sidewalls 216 of the encapsulant 202. The insulating layer 226 is separated and spaced apart from the first surface 206 of the die 204 and the first surface 212 of the encapsulant 202 by the adhesive layer 222.

A conductive structure 230 extends through the insulating layer 226 and the adhesive layer 222 to the surface 220 of the contact pad 218 such that the conductive structure 230 is coupled to the surface 220 of the contact pad 218. The conductive structure 230 includes a first portion 232 and a second portion 234 transverse to the first portion 232. The first portion 232 may be a via portion of the conductive structure 230, and the second portion 234 may be a contact portion of the conductive structure 230. A solder ball 236 is on the second portion 234 of the conductive structure 230. The second portion 234 may be an under bump metallization (UBM) structure or some other suitable structure. The solder ball 236 may be utilized to mount the semiconductor package 200 to an external electrical component (*e.g*., a printed circuit board (PCB), another semiconductor package, another semiconductor die, a carrier, etc.).

While the insulating layer 226 is shown as a single insulating layer in Figure 2, in some alternative embodiments, the insulating layer 226 may be one of a plurality of insulating layers that are present on the adhesive layer 222. In other words, the single insulating layer 226 may be replaced with a plurality of insulating layers that are stacked on each other and are stacked on the adhesive layer 206. When the single insulating layer 226 is replaced with the plurality of insulating layers, the conductive structure 230 extends through the plurality of insulating layers and the adhesive layer 222 to the surface 220 of the contact pad 218 such that the conductive structure 230 is on the contact pad 218 and is coupled to the surface 220 of the contact pad 218.

Figure 3 is a cross-sectional side view of an alternative embodiment of a semiconductor package 300. Unlike the semiconductor package 200 in which the second surface 214 of the encapsulant 202 is spaced apart from the second surface 208 of the die 204, in the semiconductor package 300 the second surface 214 is coplanar with the second surface 208 of the die 204. For example, the second surface 214 may be manufactured flush with the second surface 208 by removing (*e.g*., grinding) a respective portion of the encapsulant 202 that was previously present on the second surface 208, for example, the portion of the encapsulant 202 that is on the second surface 208 that is shown in Figure 2 of the present disclosure.

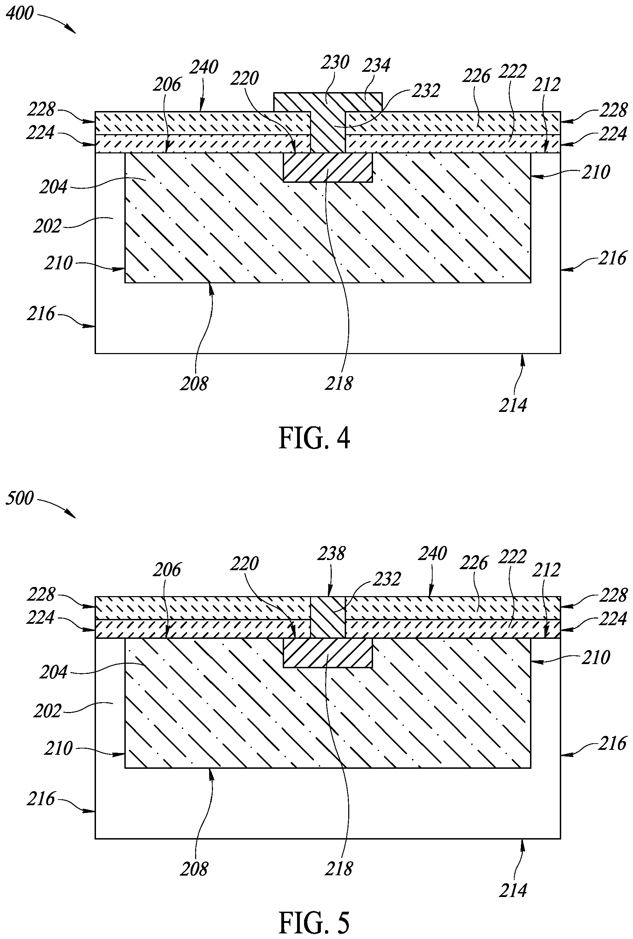

Figure 4 is a cross-sectional side view of an alternative embodiment of a semiconductor package 400. Unlike the semiconductor package 200 in which the solder ball 236 is on the conductive structure 230, in the semiconductor package 400 the second portion 234 is exposed as the solder ball 236 is not yet present on the second portion 234 of the conductive structure 230.

Figure 5 is a cross-sectional view of an alternative embodiment of a semiconductor package 500. Unlike the semiconductor package 200 in which the conductive structure 230 includes both the first portion 232 and the second portion 234, the conductive structure 230 does not include the second portion 234, and, instead, the first portion 232 includes an end surface 238 that is coplanar with a surface 240 of the insulating layer 226. In some embodiments, the end surface 238 of the first portion 232 may be slightly raised relative to the surface 240 of the insulating layer 226 such that the first portion 232 protrudes outward from the surface 240 of the insulating layer 226. In some embodiments, the end surface 238 of the first portion 232 may be recessed relative to surface 240 of the insulating layer 226 such that the first portion 232 is recessed inward from the surface 240 of the insulating layer 226.

While the embodiments of the semiconductor packages 200, 300, 400, 500 of the present disclosure include the one die 204, it will be readily appreciated alternative embodiments of semiconductor packages within the scope of the present disclosure may include more than the one die 204. For example, these alternative embodiments of semiconductor packages within the scope of the present disclosure may include a pair of die, three die, or any other number of die, which may depend on how a wafer structure is singulated along various singulation lines.

While the embodiments of the semiconductor packages 200, 300, 400, 500 of the present disclosure include one insulating or non-conductive layer 226, it will be readily appreciated alternative embodiments of semiconductor packages within the scope of the present disclosure may include more than the one insulating layer 226. For example, these alternative embodiments of semiconductor packages within the scope of the present disclosure may include a pair of insulating layers, three insulating layers, or any other number of insulating layers that are stacked on each other.

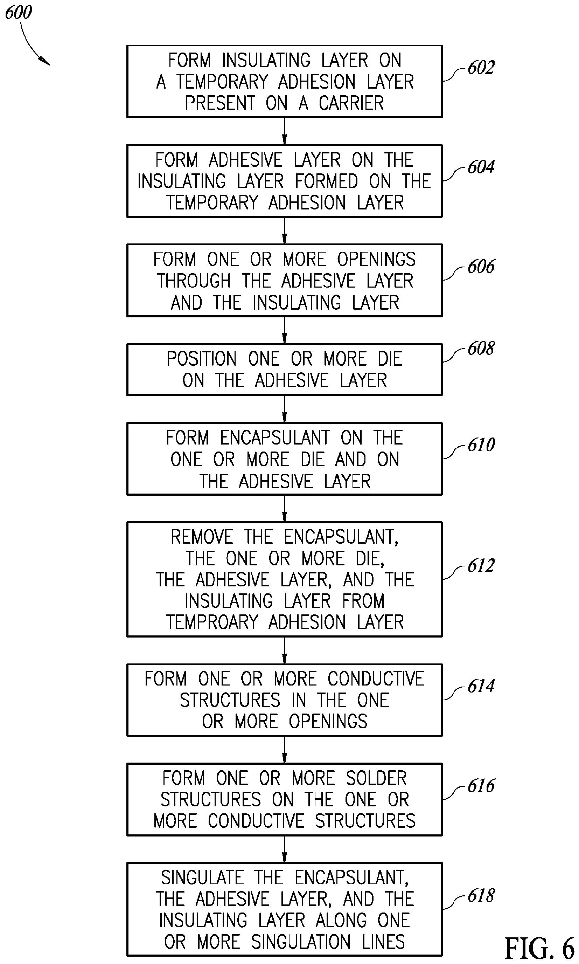

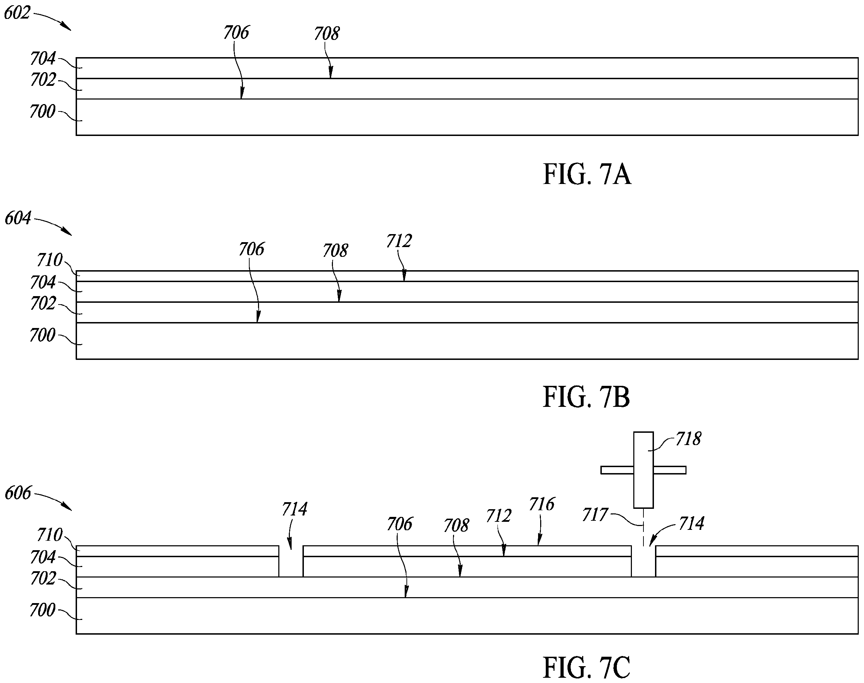

Figure 6 is a flowchart 600 of an embodiment of a method of manufacturing the embodiment of the PLP of the present disclosure as shown in Figure 3. The respective steps 602, 604, 606, 608, 612, 614, 616, 618 in the flowchart 600 will be discussed in detail with respect to the various cross-sectional side views as shown in Figures 7A-7H that are representative of the respective steps 602, 604, 606, 608, 612, 614, 616, 618 in the flowchart 600.

Figure 7A is a cross-sectional side view of a carrier 700 on which a temporary adhesion layer 702 is present. The temporary adhesion layer 702 may have been previously applied to, formed on, or deposited on a surface 706 of the carrier 700. For example, in some embodiments, the temporary adhesion layer 702 may be a tape such that the tape is adhered to the surface 706 of the carrier 700 and such that an insulating or non-conductive layer 704 is formed on the tape. In some embodiments, when the temporary adhesion layer 702 is the tape, the temporary adhesion layer 702 may be a double-sided tape that may have adhesive material on both sides of the double-sided tape. Alternatively, the temporary adhesion layer 702 may be a layer of temporary adhesion material (*e.g*., a temporary adhesive) that may be formed or deposited onto the surface 706 of the carrier 700. The carrier 700 may be a dummy wafer (*e.g*., an inactive silicon wafer) or some other type of carrier on which the temporary adhesion layer 702 is present.

In a first step 602, the insulating layer 704 is formed on the temporary adhesion layer 702. The insulating layer 704 may be formed on a surface 708 of the temporary adhesion layer 702 by a lamination technique known within the semiconductor industry. For example, this lamination technique may be a vacuum lamination technique in which a thin film of the insulating layer 704 is formed on the surface 708 of the temporary adhesion layer 702. In some embodiments, the insulating layer 704 may be a build-up film that includes an electrically non-conductive polymer material, for example, the insulating layer 704 may be an Ajinomoto Build-up Film ^{®} (ABF). The surface 708 of the temporary adhesion layer 702 faces away from the surface 706 of the carrier 700. The insulating layer 704 is spaced apart from the surface 706 of the carrier 700 by the temporary adhesion layer 702.

After the first step 602 as shown in Figure 7A in which the insulating layer 704 is formed, in a second step 604 as shown in Figure 7B an adhesive layer 710 is formed on a surface 712 of the insulating layer 704. The adhesive layer 710 may be a non-conductive glue, a die attach film (DAF), or some other non-conductive or insulating adhesive layer that is formed on the surface 712 of the insulating layer 704 by a depositing technique known to the semiconductor industry. For example, the depositing technique may be a lamination technique, a sputtering technique, or some other technique known within the semiconductor industry to form the adhesive layer 710 on the surface 712 of the insulating layer 704.

In some embodiments, the insulating layer 704, which again may be an ABF material, may have a thickness greater than or equal to 10-microns. In some embodiments, the adhesive layer 710 may have a thickness greater than or equal to 5-microns.

After the second step 604 as shown in Figure 7B in which the adhesive layer 710 is formed, in a third step 606 as shown in Figure 7C one or more openings 714 extend into a surface 716 of the adhesive layer 710. The one or more openings 714 extend through the adhesive layer 710 and the insulating layer 704 to the temporary adhesion layer 702. The one or more openings 714 are formed by utilizing a laser 717 emitted by a laser source head 718. While only one laser source head 718 is shown, in some embodiments, a plurality of laser source heads 718 may be utilized in tandem to form multiple ones of the one or more openings 714 simultaneously. The adhesive layer 710 and the insulating layer 704 are exposed to the laser 717 emitted by the laser source head 718 such that the one or more openings 714 extend all the way to the temporary adhesion layer 702 but do not extend to the surface 706 of the carrier 700.

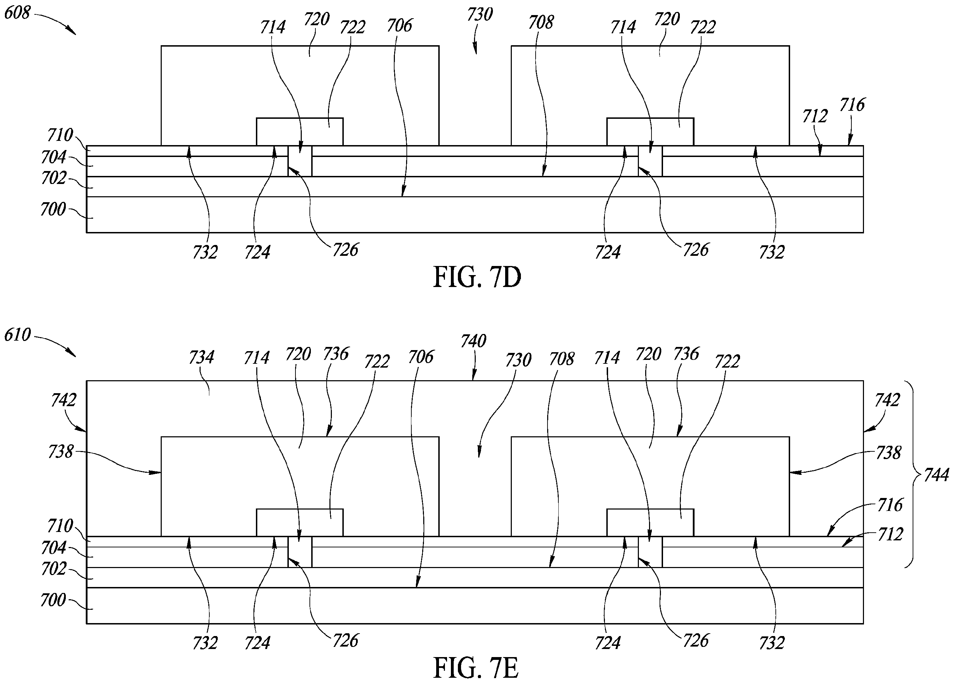

After the third step 606 as shown in Figure 7C in which the one or more openings 714 are formed, in a fourth step 608 as shown in Figure 7D one or more die 720 are positioned on and coupled to the surface 716 of the adhesive layer 710. Each respective die 720 of the one or more die 720 includes at least one pad 722. Each respective pad 722 of each respective die 720 of the one or more die 720 overlaps at least a respective opening of the one or more openings 714. For example, as shown in Figure 7D, the pad 722 of the die 720 at the left-hand side of Figure 7D overlaps and extends across the opening 714 at the left-hand side of Figure 7D, and the pad 722 of the die 720 at the right-hand side of Figure 7D overlaps and extends across the opening 714 at the right-hand side of Figure 7D. The one or more die 720 may be coupled to the surface 716 of the adhesive layer 710 by a pick-and-place tool or by some other tool or technique for coupling the one or more die 720 to the surface 716 of the adhesive layer 710. For example, when the pick-and-place tool is utilized, the pick-and-place machine picks up the one or more die 720 and presses them down onto the surface 716 of the adhesive layer 710 such that the one or more die 720 become adhered to the surface 716 of the adhesive layer 710. As shown in Figure 7D, each respective pad 722 of each respective die 720 of the one or more die 720 extends fully across the respective opening 714 of the one or more openings 714. After the one or more die 720 have been coupled to the surface 716 of the adhesive layer 710, each respective opening 714 of the one or more openings is sealed by a surface 724 of the respective pad 722 and sidewalls 726 including respective sidewalls of the insulating layer 704 and the adhesive layer 710. The one or more die 720 as shown in Figure 7D (*e.g*., at the left-hand side and right-hand side of Figure 7D) are spaced apart by a gap 730. Each respective die 720 of the one or more die 720 includes a first surface 732 at which the respective pad 722 is present and that is coupled to the surface 716 of the adhesive layer 710.

After the fourth step 608 as shown in Figure 7D in which the one or more die 720 are coupled to the surface 716 of the adhesive layer 710, in a fifth step 610 as shown in Figure 7E an encapsulant 734 is formed on the one or more die 720 and on the surface 716 of the adhesive layer 710. The encapsulant 734 may be formed utilizing a compression molding technique, an injection molding technique, or some other technique to form the encapsulant 734 as shown in Figure 7E. Forming the encapsulant 734 includes covering second surfaces 736 of the one or more die 720 opposite to the first surfaces 732 of the one or more die 720 and covering sidewalls 738 of the one or more die 720 that are transverse to the first and second surfaces 732, 736 of the one or more die 720. The sidewalls 738 extend between opposite ones of the first and second surfaces 732, 736 of the one or more die 720.

The encapsulant 734 includes a surface 740 that is spaced apart from the second surfaces 736 of the one or more die 720 and sidewalls 742 that are spaced apart from the sidewalls 738 of the one or more die 720. For example, the surface 740 is spaced apart in a first direction (*e.g*., vertically based on the orientation as shown in Figure 7E) directed from the second surfaces 736 of the one or more die 720 towards the surface 740 of the encapsulant 734, and the sidewalls 742 of the encapsulant are spaced apart from the sidewalls 738 in a second direction (*e.g*., horizontally or laterally based on the orientation as shown in Figure 7E) directed from the sidewalls 738 of the one or more die 720 to the sidewalls 742 of the encapsulant 734. The first direction is transverse to the second direction, and the first direction may be orthogonal or perpendicular to the second direction. The encapsulant 734 may be a molding compound, a non-conductive resin, an insulating resin, an epoxy resin, a resin, or some other suitable material for the encapsulant 734 known within the semiconductor industry.

After the encapsulant 734 is formed, the encapsulant 734 may be allowed to cure and hardened such that a wafer structure 744 is formed as is present on the temporary adhesion layer 702 and the carrier 700. For example, the wafer structure 744 is on and coupled to the surface 708 of the temporary adhesion layer 702. The wafer structure 744 includes the insulating layer 704, the adhesive layer 710, the one or more die 720, and the encapsulant 734.

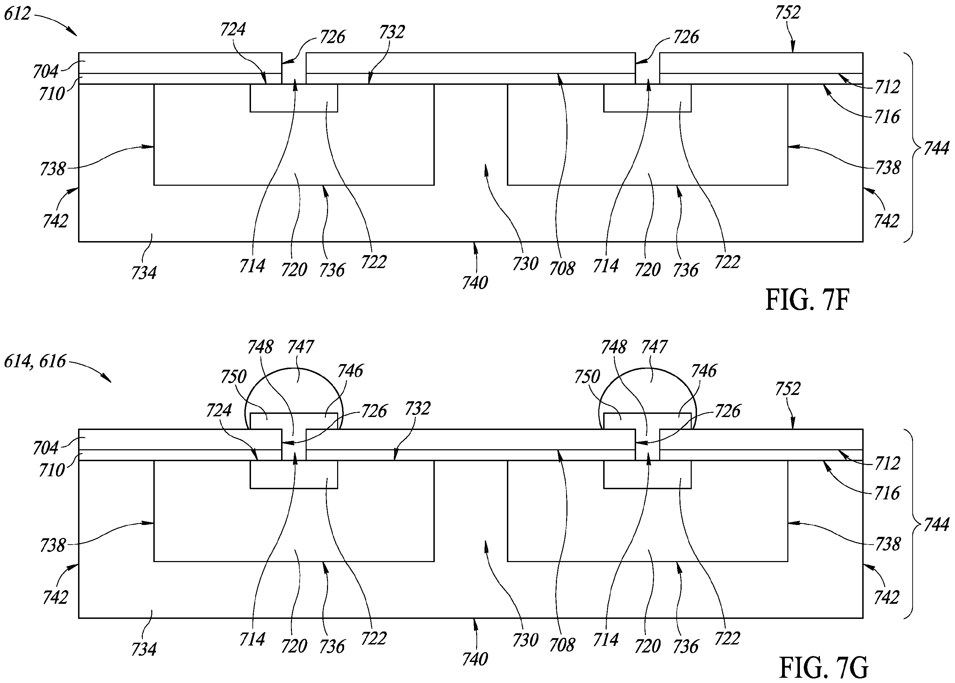

After the fifth step 610 as shown in Figure 7E in which the encapsulant 734 is formed, in a sixth step 612 as shown in Figure 7F the wafer structure 744 is removed from the surface 708 of the temporary adhesion layer 702. In some embodiments, the wafer structure 744 may be removed from the surface 708 of the temporary adhesion layer 702 by deteriorating the temporary adhesion layer 702 by exposing the temporary adhesion layer 702 to water, heat, or some other quality that may deteriorate the temporary adhesion layer 702 at which point the wafer structure 744 may be removed from the surface 708 of the temporary adhesion layer 702 by a pick-and-place tool. Alternatively, in some embodiments, the wafer structure 744 may be removed simply by overcoming an adhesion force between the temporary adhesion layer 702 and the wafer structure 744 utilizing a pick-and-place machine (*e.g*., pulling upward on the wafer structure 744 based on the orientation as shown in Figure 7E). As shown in Figure 7F, the wafer structure 744 may then be flipped such that the one or more openings 714 are more easily and readily accessible for further processing and manufacturing steps. For example, the wafer structure 744 may be flipped utilizing a flip-chip technique known within the semiconductor industry.

After the sixth step 612 in which the wafer structure 744 is removed from the surface 708 of the temporary adhesion layer 702 and is flipped, in a seventh step 614 as shown in Figure 7G one or more conductive structures 746 are formed. After the seventh step 614 in which the one or more conductive structures 746 are formed, in an eighth step 616 as shown in Figure 7G one or more solder structures 747 are formed on the one or more conductive structures 746. As shown in Figure 7G, the one or more conductive structures 746 are formed within the one or more openings 714. The one or more openings are filled by first portions 748 of the one or more conductive structures 746 and second portions 750 of the one or more conductive structures 746 are present on the insulating layer 704. The second portions 750 are transverse to the first portions 748. The first portions 748 are present on the surfaces 724 of the pads 722 of the one or more die 720. In some embodiments, each one of the one or more die 720 may have a thickness substantially equal to 150-microns or may have a thickness greater than 150-microns

In the seventh step 614, the conductive structures 746 may be formed by performing one or more plating steps along with one or more mask steps. For example, the first portions 748 of the conductive structures 746 may be formed by performing a first plating step in which a conductive material is formed on the surfaces 724 of the pads 722 exposed by the one or more openings 714. After the first portions 748 have been formed, a mask layer (not shown) may be formed on a surface 752 of the insulating layer 704, which is opposite to the surface 712 of the insulating layer 704. After the mask layer is formed, the mask layer may be patterned with respective openings to expose respective end surfaces of the first portions 748. After the mask layer is patterned with the respective openings, a second plating step is performed in which a conductive material is formed on the respective end surfaces of the first portions 748 and with the respective openings forming the second portions 750 of the conductive structures 746. After the second portions 750 of the conductive structures 746 are formed, the mask layer is removed such that the conductive structures 746 have a T-like shape as shown in Figure 7G. In some alternative embodiments, only the first portions 748 of the conductive structures 746 may be formed such that the second portions 750 of the conductive structures 746 are not present and the conductive structure 746 are pillars (for example, see Figure 5 of the present disclosure).

After the conductive structures 746 are formed in the seventh step 614, in the eighth step 616 the solder structures 747 are formed on the second portions 750 of the conductive structures 746. For example, in some embodiments, a stencil (not shown) may be placed on the surface 752 of the insulating layer 704 with openings in the stencil overlapping and aligned with the second portions 750 of the conductive structures 746. After the stencil is placed on the surface 752, the openings in the stencil may be filled with a solder material such that the solder material is on the second portions 750 of the conductive structures 746. The solder material may be allowed to cure and harden at which point the stencil may be removed. After the stencil is removed, a solder reflow step may be carried out such that the solder material is shaped into the solder structures 747 as shown in Figure 7G. The solder structures 747 as shown in Figure 7G may be referred to as solder balls.

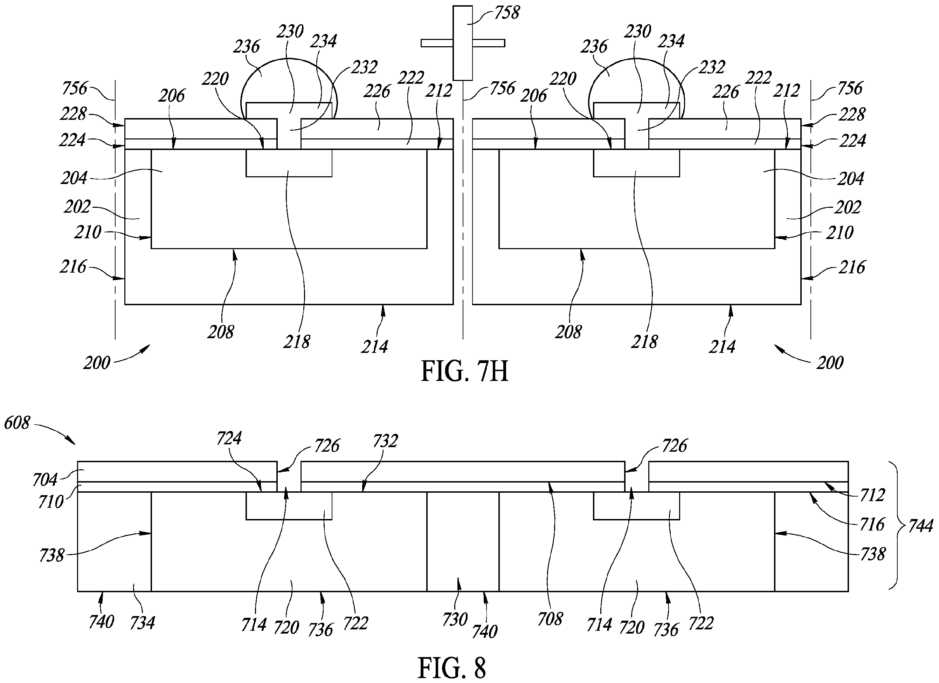

After the seventh and eighth steps 614, 616 in which the conductive structures 746 and the solder structures 747 are formed, respectively, in a ninth step 618 is shown in Figure 7H in which the wafer structure 744 is singulated into individual ones of the semiconductor packages 200 as shown in Figure 2. The wafer structure 744 is singulated along singulation lines 756 by a singulation tool 758, which may be a sawing tool, a cutting tool, a laser tool, or some other type of singulation tool known to the semiconductor industry for singulating the wafer structure 744 along the singulation lines 758. At least one of the singulation lines 756 is along the gap 730 that was previously filled by the encapsulant 734 in the fourth step 608. Singulating the wafer structure 744 along the singulation lines 758 forms the respective sidewalls 216, 224, 228 of the respective layers of the semiconductor package 200 as shown in Figure 2 such that the respective sidewalls 216, 224, 228 are substantially coplanar and flush with each other as shown and discussed above with respect to Figure 2.

In view of the above discussion, while forming the openings 108 through the insulating layer 106 to the contact pads 112 of the substrate 116 may cause damage to the contact pads 112 due to being exposed to laser 104 in forming the openings 108, the at least one pad 722 is not exposed to the laser 717 as the openings 714 are formed in advance of the at least one die 720 being coupled to the adhesive layer 710. As the at least one pad 722 is not exposed to the laser 717, the at least one pad 722 is not damaged by the laser 717. As damage to the contact pads 112 that may occur when forming the openings 108 with the laser 104 is prevented by forming the openings 714 earlier on in method of the flowchart 600, this prevention of damage in the at least one pad 722 increases a yield of semiconductor packages that are manufactured by a semiconductor manufacturing plant (FAB). For example, this prevention of damage to the at least one pad 722 may result in an increased units per hour (UPH) manufactured by the FAB.

Figure 8 is a cross-sectional view of a respective step of an alternative method of manufacturing some embodiments within the scope of the present disclosure. As shown in Figure 8, the encapsulant 734 has been removed on one side of the wafer structure 744 such that the surfaces 736 of the one or more die 720 are coplanar and flush with the surface 740 of the encapsulant 734. The encapsulant 734 may have been removed utilizing a grinding technique or some other suitable removal technique for exposing the surfaces 736 of the one or more die 720 from the encapsulant 734 and such that the surface 740 of the encapsulant is flush and coplanar with the surfaces 736 of the one or more die 720. For example, the semiconductor package 300 may be manufactured with the alternative method including this additional removal step, which could be completed after the fifth step 610 of the method in the flowchart 600.

An embodiment of a device of the present disclosure may be summarized as including: a semiconductor die including a first surface, a second surface opposite to the first surface, a first sidewall transverse to the first and second surfaces, and a contact pad at the first surface; an encapsulant on the second surface and on the first sidewall, the encapsulant including a second sidewall; an adhesive layer on the encapsulant and on the first surface of the semiconductor die, the adhesive layer including a third sidewall coplanar with the second sidewall; an insulating layer on the adhesive layer, the insulating layer including a fourth sidewall coplanar with the second sidewall and the third sidewall, respectively; and a conductive structure extending through the adhesive layer and the insulating layer to the contact pad of the semiconductor die.

The encapsulant may include a third surface coplanar with the first surface of the semiconductor die.

The adhesive layer may be on the third surface of the encapsulant, and the adhesive layer may separate the first surface of the semiconductor die and the third surface of the encapsulant from the insulating layer.

The adhesive layer may be on the contact pad.

The conductive structure may include a fifth sidewall transverse to the first surface of the semiconductor die; and the adhesive layer and the insulating layer may cover the fifth sidewall of the conductive structure.

The conductive structure may include: a first portion that extends through the adhesive layer and the insulating layer to the contact pad; and a second portion transverse to the first portion, the second portion exposed from the insulating layer.

An embodiment of a method of the present disclosure may be summarized as including: forming an insulating layer on a temporary adhesion layer on a carrier; forming an adhesive layer on the insulating layer; forming an opening extending through the insulating layer and the adhesive layer; coupling a semiconductor die to the adhesive layer including overlapping and aligning a contact pad of the semiconductor die with the opening; forming an encapsulant on the adhesive layer, on a surface of the semiconductor die, and on a first sidewall of the semiconductor die transverse to the surface of the semiconductor die; removing the insulating layer, the adhesive layer, the semiconductor die, and the encapsulant from the temporary adhesion layer on the carrier and from the carrier exposing the opening; and forming a conductive structure in the opening and on a surface of the contact pad.

Forming the opening through the insulating layer and the adhesive layer to the temporary adhesion layer may include exposing the insulating layer and the adhesive layer to a laser.

Exposing the insulating layer and the adhesive layer to the laser may include stopping the laser once the laser reaches the temporary adhesion layer.

The method may further include removing a portion of the encapsulant to expose the surface of the semiconductor die.

Forming the opening may include forming the opening extending to the temporary adhesion layer.

An embodiment of a method of the present disclosure may be summarized as including: forming a wafer including: forming an insulating layer on a temporary adhesion layer on a carrier; forming an adhesive layer on the insulating layer; forming a plurality of openings extending through the adhesive layer and the insulating layer; coupling a plurality of die to the adhesive layer, each die of the plurality of die overlapping at least one opening of the plurality of openings; and forming an encapsulant on the adhesive layer and on the plurality of die.

Forming the plurality of openings may include exposing the adhesive layer and the insulating layer to a laser.

Coupling the plurality of die to the adhesive layer may include aligning a contact pad of each die of the plurality of die with at least one opening of the plurality of openings.

The method may further include removing a portion of the encapsulant exposing respective surfaces of the plurality of die facing away from the adhesive layer and the insulating layer.

The method may further include singulating the panel wafer along a plurality of singulation lines, and wherein removing the portion of the encapsulant may occur before singulating the panel wafer along the plurality of singulation lines.

The method may further include forming a plurality of solder balls on the plurality of conductive structures.

The method may further include removing the wafer from the temporary adhesion layer of the carrier.

The method may further include, after removing the wafer from the temporary adhesion layer, forming a plurality of conductive structures in the plurality of openings, each conductive structure of the plurality of conductive structures being in a corresponding opening of the plurality of openings.

The method may further include, after forming the plurality of conductive structures, singulating the wafer along a plurality of singulation lines, each singulation line of the plurality of singulation lines being between at least a pair of adjacent die of the plurality of die.

The various embodiments described above can be combined to provide further embodiments. Aspects of the embodiments can be modified, if necessary to employ concepts of the various patents, applications and publications to provide yet further embodiments.

These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

## Claims

1. A device, comprising:
a semiconductor die including a first surface, a second surface opposite to the first surface, a first sidewall transverse to the first and second surfaces, and a contact pad at the first surface;
an encapsulant on the second surface and on the first sidewall, the encapsulant including a second sidewall;
an adhesive layer on the encapsulant and on the first surface of the semiconductor die, the adhesive layer including a third sidewall coplanar with the second sidewall;
an insulating layer on the adhesive layer, the insulating layer including a fourth sidewall coplanar with the second sidewall and the third sidewall, respectively; and
a conductive structure extending through the adhesive layer and the insulating layer to the contact pad of the semiconductor die.

2. The device of claim 1, wherein the encapsulant includes a third surface coplanar with the first surface of the semiconductor die.

3. The device of claim 2, wherein the adhesive layer is on the third surface of the encapsulant, and the adhesive layer separates the first surface of the semiconductor die and the third surface of the encapsulant from the insulating layer.

4. The device of claim 1, wherein the adhesive layer is on the contact pad.

5. The device of claim 1, wherein:
the conductive structure includes a fifth sidewall transverse to the first surface of the semiconductor die; and
the adhesive layer and the insulating layer cover the fifth sidewall of the conductive structure.

6. The device of claim 1, wherein the conductive structure includes:
a first portion that extends through the adhesive layer and the insulating layer to the contact pad; and
a second portion transverse to the first portion, the second portion exposed from the insulating layer.

7. A method, comprising:
forming an insulating layer on a temporary adhesion layer on a carrier;
forming an adhesive layer on the insulating layer;
forming an opening extending through the insulating layer and the adhesive layer;
coupling a semiconductor die to the adhesive layer including overlapping and aligning a contact pad of the semiconductor die with the opening;
forming an encapsulant on the adhesive layer, on a surface of the semiconductor die, and on a first sidewall of the semiconductor die transverse to the surface of the semiconductor die;
removing the insulating layer, the adhesive layer, the semiconductor die, and the encapsulant from the temporary adhesion layer on the carrier and from the carrier exposing the opening; and
forming a conductive structure in the opening and on a surface of the contact pad.

8. The method of claim 7, wherein forming the opening through the insulating layer and the adhesive layer to the temporary adhesion layer by exposing the insulating layer and the adhesive layer to a laser.

9. The method of claim 8, wherein exposing the insulating layer and the adhesive layer to the laser includes stopping the laser once the laser reaches the temporary adhesion layer.

10. The method of claim 7, further comprising removing a portion of the encapsulant to expose the surface of the semiconductor die.

11. The method of claim 7, wherein forming the opening includes forming the opening extending to the temporary adhesion layer.

12. A method, comprising:
forming a panel wafer including:
forming an insulating layer on a temporary adhesion layer on a carrier;
forming an adhesive layer on the insulating layer;
forming a plurality of openings extending through the adhesive layer and the insulating layer;
coupling a plurality of die to the adhesive layer, each die of the plurality of die overlapping at least one opening of the plurality of openings; and
forming an encapsulant on the adhesive layer and on the plurality of die.

13. The method of claim 12, wherein forming the plurality of openings including exposing the adhesive layer and the insulating layer to a laser.

14. The method of claim 12, wherein coupling the plurality of die to the adhesive layer includes aligning a contact pad of each die of the plurality of die with at least one opening of the plurality of openings.

15. The method of claim 12, further comprising removing a portion of the encapsulant exposing respective surfaces of the plurality of die facing away from the adhesive layer and the insulating layer.

16. The method of claim 15, further comprising singulating the panel wafer along a plurality of singulation lines, and wherein removing the portion of the encapsulant occurs before singulating the panel wafer along the plurality of singulation lines.

17. The method of claim 12, further comprising forming a plurality of conductive structures in the plurality of openings.

18. The method of claim 12, further comprising removing the panel wafer from the temporary adhesion layer of the carrier.

19. The method of claim 18, further comprising, after removing the panel wafer from the temporary adhesion layer, forming a plurality of conductive structures in the plurality of openings, each conductive structure of the plurality of conductive structures being in a corresponding opening of the plurality of openings.

20. The method of claim 19, further comprising, after forming the plurality of conductive structures, singulating the panel wafer along a plurality of singulation lines, each singulation line of the plurality of singulation lines being between at least a pair of adjacent die of the plurality of die.
